# EUROPEAN PATENT APPLICATION

(11) **EP 3 836 195 A1**
(43) Date of publication of application: **16.06.2021**
(21) Application number: 20201709.1
(22) Date of filing: 14.10.2020
(51) Int. Cl.: H01L 21/3065

(54) **METHOD, SUBSTRATE AND APPARATUS**

(30) Priority: 04.12.2019 GB 201917734
(71) Applicant: SPTS Technologies Limited, Newport Gwent NP18 2TA (GB)
(72) Inventor: Ashraf, Huma, Newport, Gwent NP18 2TA (GB); Riddell, Kevin, Newport, Gwent NP18 2TA (GB); Croot, Alex, Newport, Gwent NP18 2TA (GB)
(74) Representative: Wynne-Jones IP Limited

(57) **Abstract**

According to the present invention there is provided a method of plasma etching a compound semiconductor substrate to form a feature, the method comprising the steps of:
(a) providing a substrate with a mask formed thereon, the mask having an opening, wherein the substrate is formed from a compound semiconductor material;
(b) performing a first plasma etch step to anisotropically etch the substrate through the opening to produce a partially formed feature having a bottom surface comprising a peripheral region; and
(c) performing a second plasma etch step to anisotropically etch the bottom surface of the partially formed feature through the opening while depositing a passivation material onto the mask so as to reduce a dimension of the opening, wherein the reduction of the dimension of the opening causes an attenuation in etching of the peripheral region thereby producing a fully formed feature having a bottom surface comprising a central region and an edge region, wherein the central region is deeper than the edge region of the bottom surface of the fully formed feature.

## Description

This invention relates to a method of plasma etching a feature in a compound semiconductor substrate. This invention also relates to a compound semiconductor substrate formed using the aforementioned method. This invention also relates to a plasma etching apparatus.

There is growing demand for high power and high frequency devices based on compound semiconductors which cannot be met by conventional silicon-based technology. In particular, wide band-gap compound semiconductors, such as silicon carbide (SiC), combine excellent electronic and thermal properties which can exceed those of silicon. However, fabricating such compound semiconductor devices in high volumes at an acceptable cost using known methods can be challenging, often requiring many processing steps. It is desirable to develop a method to fabricate compound semiconductor devices, such as SiC devices, in a more economical way with fewer processing steps.

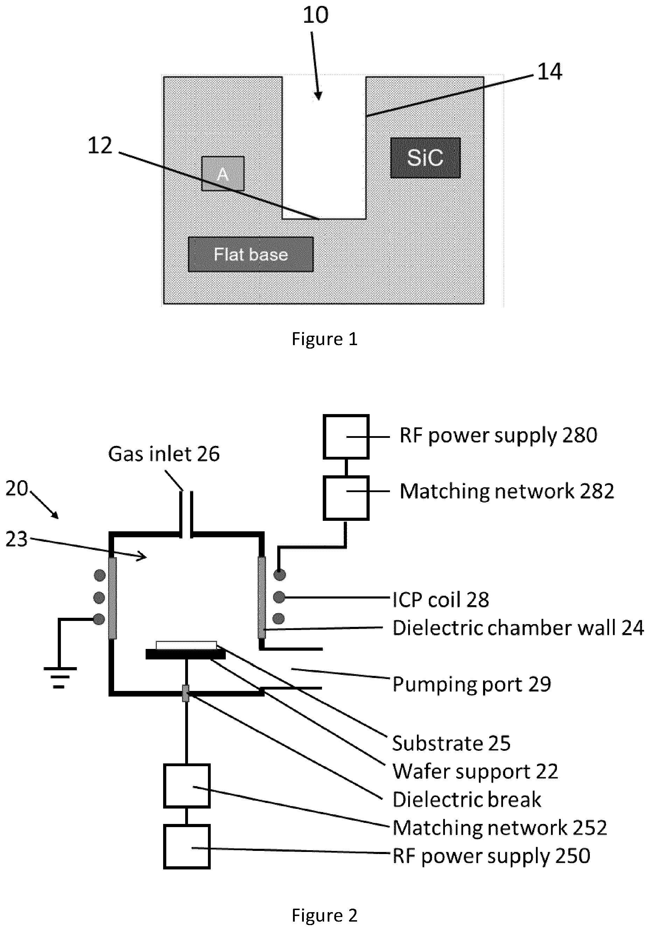

Power device silicon carbide trenches are finding an increasing number of applications in power semiconductor devices. It is known to use flat-based trenches, wherein the trench 10 has a substantially flat bottom surface 12 with substantially perpendicular sidewalls 14, as shown in Figure 1. However, micro-trenching at the bottom of flat-based trenches can cause problems. Micro-trenching refers to deeper etched sections at the corners of the trench. The acute angles inherent in micro-trenches can cause electric fields within the substrate to be concentrated at these locations, which can lead to reduced breakdown voltages. It is desirable to avoid micro-trenching; and to maximise the breakdown voltage.

Even in flat-bottomed tranches (without micro-trenching), the electric field is susceptible to "field bunching". That is, the electric field is susceptible to concentrating at a particular location within the trench, such as at a trench corner. It is therefore desirable to minimise field bunching as far as possible.

The present invention, in at least some of its embodiments, seeks to address the above described problems, desires and needs. In particular, the present invention seeks to provide a method for controlling the profile at the bottom of trenches in order to better disperse the internal electric fields within a trench, and to increase breakdown voltages. For example, at least some embodiments of the present invention provide a method for controllably forming trenches with a base having rounded corners or a rounded profile.

According to a first aspect of the present invention there is provided a method of plasma etching a compound semiconductor substrate to form a feature, the method comprising the steps of:
(a) providing a substrate with a mask formed thereon, the mask having an opening, wherein the substrate is formed from a compound semiconductor material;
(b) performing a first plasma etch step to anisotropically etch the substrate through the opening to produce a partially formed feature having a bottom surface comprising a peripheral region; and
(c) performing a second plasma etch step to anisotropically etch the bottom surface of the partially formed feature through the opening while depositing a passivation material onto the mask so as to reduce a dimension of the opening, wherein the reduction of the dimension of the opening causes an attenuation in etching of the peripheral region thereby producing a fully formed feature having a bottom surface comprising a central region and an edge region, wherein the central region is deeper than the edge region of the bottom surface of the fully formed feature.

Without wishing to be bound by any theory or conjecture, it is believed that the passivation material that deposits onto the mask to reduce the dimension of the opening protects the peripheral region of the partially formed feature from the distribution of species in the plasma during the second plasma etch step. Consequently, the amount of material removed from the peripheral region during the second plasma etch step is less than the amount of material removed from the central region. Controlling the reduction in dimension of the opening during the second plasma etch step allows the profile at the bottom of the feature to be controlled and formed into a desired shape. The present method allows features to have rounded, curved or otherwise smooth surfaces (i.e. gradual changes in slope), which can improve the dispersion of electric fields in the feature and can help to minimise field bunching. Consequently, the present method can help to produce features having a high breakdown voltage. Additionally, the method can help to avoid the formation of micro-trenches forming in the edge region of the bottom surface (e.g. the corners) of the feature.

The passivation material can be deposited onto the mask and a sidewall of the feature being etched. The passivation material can be deposited onto a sidewall of the mask. The passivation material can be deposited at a deposition rate that increases during the second plasma etch step. The deposition rate of the passivation material can increase during the second plasma etch step at an increasing rate of change. The dimension of the opening in the mask can reduce at an increasing rate of change. Increasing the deposition rate of the passivation material during the second plasma etch step can help to produce a feature having rounded corners in the edge region of the bottom surface. For example, the feature can be a generally flat-bottomed U-shape. The passivation material can have a deposition thickness that increases to about 300 nm, optionally about 250 nm, optionally about 175 nm, optionally about 150 nm, or optionally about 125 nm on each side of the opening. The dimension of the opening in the mask layer can be reduced by a distance of about 100-600 nm, 200-500 nm, 250-450 nm, 300-400 nm, or about 350 nm or any combination of these upper and lower limits.

The second plasma etch step can comprise varying a process parameter during the second plasma etch step. The second plasma etch step can comprise ramping a process parameter during the second plasma etch step. For example, the second plasma etch step can comprise varying or ramping at least one of a gas mixture composition, a gas flow rate, a processing time, a plasma source power, a bias power applied to the substrate, and/or a frequency. Any other process parameter can be varied or ramped during the second plasma etch step. This can help to control the etch rate of the substrate through the opening whilst also controlling the deposition rate of the passivation material.

The process parameter that is varied can be ramped at an increasing rate of change. The process parameter that is varied can be ramped at a constant rate of change. The term "ramping" can mean either systematically increasing or systematically decreasing a value.

Varying the process parameter can comprise varying a flow rate of a passivation material precursor during the second plasma etch step.

The flow rate of the passivation material precursor can be increased during the second plasma etch step. The flow rate (in seem) of the passivation material precursor at the end of the second plasma etch step can be at least two times, three times or four times higher than the flow rate (in seem) of the passivation material precursor at the start of the second plasma etch step. The flow rate of the passivation material can be increased from about 25 sccm to about 100 seem.

The substrate can be disposed in a chamber. The method can comprise introducing a passivation material precursor into the chamber at a flow rate that is higher during the second plasma etch step compared to the first plasma etch step. The second plasma etch step can comprise introducing a passivation material precursor into the chamber at a flow rate, wherein the flow rate of passivation material precursor introduced into the chamber during the second plasma etch step can be higher than a flow rate of passivation material precursor introduced into the chamber during the first plasma etch step.

The passivation material precursor can comprise an oxygen-containing gas, such as O₂.

Varying the process parameter can comprise varying a bias power applied to the substrate during the second plasma etch step. The bias power applied to the substrate can be decreased during the second plasma etch step. The bias power applied to the substrate at the start of the second plasma etch step can be higher than the bias power applied to the substrate at the end of the second plasma etch step by an amount in the range of about 50-300 W. The bias power applied to the substrate at the start of the second plasma etch step can be a power in the range of about 230-500 W, 240-350 W or about 250 W. The bias power applied to the substrate at or towards the end of the second plasma etch step can be a power in the range of about 140-220 W, about 170-210 W, or about 190 W. The bias power applied to the substrate during the second plasma etch step can be lower than the bias power applied to the substrate during the first plasma etch step. The bias power applied to the substrate during the first plasma etch step can be in the range of about 100-1600 W, or about 400-1400 W.

The passivation material can comprise a silicon oxide, such as SiO₂. The passivation material is typically more resistant to the plasma etch process compared with the compound semiconductor material of the substrate. The etch selectivity between the substrate material and the passivation material can be in a range of about 2:1 to about 3:1. The passivation material and the mask can be made of substantially the same material. The mask can comprise a silicon oxide, such as SiO₂.

The first plasma etch step can include using an etch recipe comprising a chlorine-based etchant, such as Cl₂ and/or SiCl₄. The first plasma etch step can include an etch recipe comprising a fluorine-based etchant, such as a fluorinated gas. The etch recipe used for the first plasma etch step can consist of or consist essentially of one or more gases selected from the group: a chlorine-based etchant (e.g. Cl₂ and/or SiCl₄), an oxygen-containing gas (e.g. O₂), H₂ and/or Ar gas.

The second plasma etch step can include using an etch recipe comprising a chlorine-based etchant. The chlorine-based etchant can comprise Cl₂ and/or SiCl₄. The second plasma etch step can include an etch recipe comprising a fluorine-based etchant, such as a fluorinated gas. The etch recipe used for the second plasma etch step can comprise using one or more gases selected from a chlorine-based or fluorine-based etchant, O₂, H₂ and/or Ar gases. The etch recipe used for the second plasma etch step can consist of or consist essentially of one or more gases selected from the group: a chlorine-based etchant (e.g. Cl₂ and/or SiCl₄), an oxygen-containing gas (e.g. O₂), H₂ and/or Ar gas. The second plasma etch step can include using an etch recipe consisting of or consisting essentially of: the chlorine-based etchant, such as Cl₂ and/or SiCl₄; an oxygen-containing gas, such as O₂ gas; optionally H₂ gas; and optionally Ar gas. The etch recipe used for the first plasma etch step can be different to the etch recipe used for the second plasma etch step. For example, the ratio of the gases used in the etch recipe for the second plasma etch step can be different to the ratio of gases used in the etch recipe for the first plasma etch step. The etch rate of the first plasma etch step can be higher than the etch rate of the second plasma etch step. Where SiCl₄ (or other silicon-containing gas) is used in the second plasma etch step, the flow rate of the silicon-containing gas (e.g. SiCl₄) in sccm can be more than about 50%, optionally between about 55% and 90% or optionally between about 62% and 86%, of the total gas flow rate in seem.

The bottom surface of the partially formed feature can be substantially flat. The bottom surface of the partially formed feature can be substantially convex. The bottom surface of the partially formed feature can comprise micro-trenches.

The feature can be a trench. The feature can be a via.

The dimension of the opening in the mask during the first plasma etch step can be in a range of about 0.5-20 µm or about 1-10 µm. The dimension of the opening can remain substantially constant during the first plasma etch step. The dimension of the opening can be a width. The feature can have a maximum width in the range of about 0.5-20 µm or about 1-10 µm. The feature can have a depth in the range of about 0.5-10 µm, 0.75-5 µm, or about 1-3 µm.

The bottom surface of the fully formed feature can be substantially concave. The term "substantially concave" is used here to mean a shape in which it is possible to draw a line segment between two points on opposite sides of the bottom surface (e.g. from opposing edge regions) without intersecting the substrate (i.e. having a central region that is deeper than the edge region). This definition includes a concave profile comprising a flat central region. This definition includes a concave profile having tapered corners. The present invention allows the profile of the bottom surface to be tailored as desired by the user.

The central region of the bottom surface of the fully formed feature can be substantially flat.

The edge region of the bottom surface of the fully formed feature can comprise a curved surface. The edge region can form a rounded corner between the central region of the bottom surface and a sidewall of the fully formed feature. The edge region can form a tapered corner between the central region of the bottom surface and a sidewall of the fully formed feature. The sidewall is typically substantially perpendicular to the central region of the bottom surface of the fully formed feature. The sidewall can be inclined at an angle of 85-90°, 86-90°, 87-90°, 88-90°, or 89-90° with respect to the central region of the bottom surface.

The compound semiconductor material can be silicon carbide (SiC). The substrate can be a SiC wafer.

The method can further comprise: (d) selectively removing the passivation material from the substrate by wet etching. The wet etching can be performed using a HF wet etchant.

Steps (b) and (c) can be performed using an inductively coupled plasma (ICP) etch apparatus.

According to a second aspect of the invention there is provided a compound semiconductor substrate comprising a feature formed using the method according to claim 1, wherein the feature comprises a bottom surface, the bottom surface including a substantially flat central region and an edge region, wherein the central region is deeper than the edge region.

The feature can comprise a sidewall that is substantially perpendicular to the central region. The feature can have a bottom surface (or base) comprising rounded corners. The edge region of the bottom surface can comprise a curved surface. The edge region can provide a continuous change in slope from the central region to a substantially perpendicular sidewall of the feature. The edge region can extend from the sidewall of the feature by a distance in the range of 100-350 nm, 125-300 nm, 150-250 nm, or optionally about 175 nm.

The feature can be a trench. The compound semiconductor substrate can be made from a compound semiconductor material. The compound semiconductor material can be silicon carbide (SiC). The compound semiconductor substrate can be a SiC wafer.

According to a third aspect of the present invention there is provided a plasma etch apparatus for plasma etching a substrate to form a feature using the method according to the first aspect, the apparatus comprising:
a chamber;
a substrate support disposed within the chamber for supporting a substrate thereon;
at least one gas inlet for introducing a gas or gas mixture into the chamber at a flow rate;
a plasma generating means for sustaining a plasma in the chamber;
a power supply for supplying a bias power to the substrate support; and
a controller configured to switch from a first set of processing conditions to a second set of processing conditions, wherein the first set of processing conditions are configured to perform a first plasma etch step to anisotropically etch the substrate through an opening in a mask to produce a partially formed feature having a bottom surface comprising a peripheral region, and the second set of processing conditions are configured to perform a second plasma etch step to anisotropically etch the bottom surface of the partially formed feature through the opening whilst depositing a passivation material onto the mask so as to reduce a dimension of the opening, wherein the reduction of the dimension of the opening causes an attenuation in etching of the peripheral region thereby producing a fully formed feature having a bottom surface comprising a central region and an edge region, wherein the central region is deeper than the edge region of the bottom surface of the fully formed feature.

Whilst the invention has been described above, it extends to any inventive combination of the features set out above, or in the following description, drawings or claims. For example, any features disclosed in relation to the first aspect of the invention may be combined with any features of the second or third aspects of the invention and *vice versa.*

Embodiments of substrates and methods in accordance with the invention will now be described with reference to the accompanying drawings, in which:
Figure 1 is a cross-sectional schematic view of a trench having a base with angled (square) corners (prior art);
Figure 2 is a cross-sectional schematic view of a plasma etch apparatus suitable for performing a method according to an embodiment of the invention;
Figure 3 is a schematic cross-sectional view of a substrate at subsequent stages of the present method;
Figure 4 is a schematic cross-sectional view of an opening in a mask layer on a substrate;
Figure 5 shows how the passivation thickness changes with a linear increase in flow rate of a passivation material precursor;
Figure 6 shows a schematic cross-sectional view of a substrate comprising a feature having a base with tapered corners;
Figure 7 shows how the passivation thickness changes with a non-linear increase in flow rate of a passivation material precursor;
Figure 8 shows a schematic cross-sectional view of a substrate comprising a feature having a base with rounded corners; and
Figure 9 shows an SEM image of a substrate comprising a feature having a base with rounded corners.

Figure 2 shows a schematic representation of a plasma etch apparatus 20 suitable for performing methods according to embodiments of the present invention. A plasma etching tool suitable for performing the method of the present invention is the Omega(RTM) Synapse™ available from SPTS Technologies Limited of Newport, UK. Plasma etching of a substrate is typically performed using a plasma etch apparatus. The plasma etch apparatus can be an inductively coupled plasma (ICP) apparatus. However, etching can also be performed using other dry etch systems, such as helicon, RIE or microwave type apparatus. The operation of generating a plasma within such plasma etch apparatus is well-known in the art and will not be described here other than where necessary for an understanding of the present invention.

A plasma etch apparatus 20 typically comprises a substrate support (or platen) 22 disposed within a chamber 23 for supporting a substrate 25. A bias power can be supplied to the substrate by a RF power supply 250 via an impedance matching network 252. The chamber can comprise a chamber wall having a dielectric part 24. Process gases can be introduced into the chamber via one or more gas inlets 26. A plasma generating means 28, such as an inductive coil, can be used to generate and sustain a plasma within the chamber 23 as is known in the art (e.g. using a RF power supply 280 and impedance matching network 282). The gases can be removed from the chamber 23 via a pumping port 29.

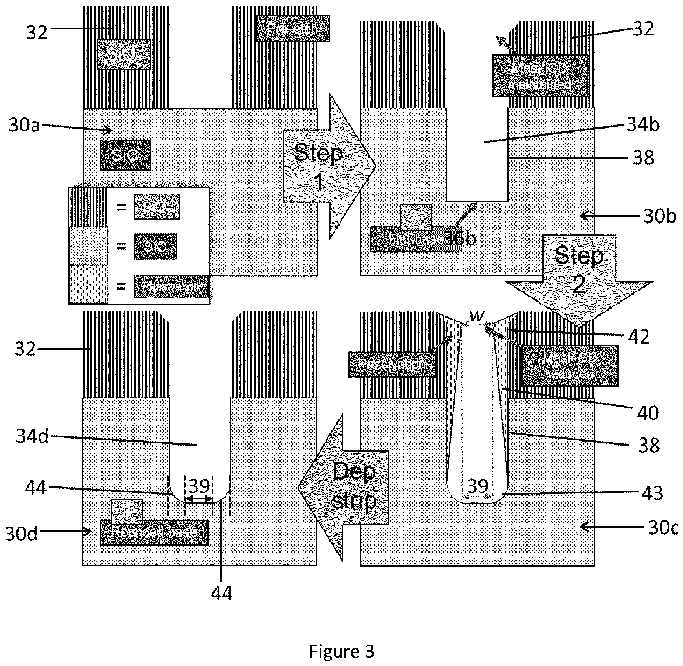

Figure 3 shows the stages of an exemplary method according to a first embodiment. In the first embodiment a compound semiconductor substrate 30 is etched to form a feature having rounded corners at the base of the feature. In the first embodiment, the feature is a trench, and the substrate 30 embodiment is a silicon carbide (SiC) wafer. However, other compound semiconductor substrates can alternatively be used. The substrate 30 includes a patterned mask layer 32, such as a silicon dioxide (SiO₂) layer or other suitable resist layer. The mask layer 32 is more resistant to the plasma etch conditions that the bulk substrate material.

The substrate to be etched is positioned on the substrate support 22 in a plasma etch apparatus 20 with the face to be etched facing upwards. A pre-etch may (optionally) be performed to prepare the substrate 30 prior to the main etch cycle, for example to remove unwanted material from the open areas of the mask layer 32.

A first plasma etch step (i.e. a main etch) is performed to selectively etch the SiC substrate 30 so that a majority of the feature is formed. Numeral 34b represents the partially formed feature. The first plasma etch step corresponds to "Step 1" of Figure 3. The first plasma etch step anisotropically etches the substrate through the opening. A bias power is applied to the platen 22 during the first plasma etch step. For example, the bias power applied to the platen can be in the range of about 100 W to 1400 W. This helps to impart a directionality to the species (e.g. ions) in the plasma so that the base of the feature is preferentially etched (rather than the sidewalls 38 of the feature). Consequently, the width of the partially formed feature substantially corresponds to the initial width of the open area in the mask layer 32.

During the first plasma etch step, the chamber pressure can be in the range of about 2 mTorr to about 20 mTorr. During the first plasma etch step, the plasma source power can be in the range of about 800 W to about 2000 W. Typically, the walls of the chamber 23 are cooled by water to about 55 °C. By way of example only, the process gases used in the main etch step can comprise one or more of Cl₂, SiCl₄, O₂, H₂ and/or Ar gas. Fluorinated etchant gases, such as fluorocarbons, can also be used.

The first plasma etch step results in the formation of a partially formed feature 34b. The partially formed feature 34b comprises a flat base 36b that is approximately perpendicular to the sidewalls 38 of the trench 34b. The flat base 36b has a peripheral region (not labelled) proximate to the sidewall 38. If micro-trenching has occurred, the partially formed feature may comprise a substantially convex shape.

The substrate 30b is then subject to a second plasma etch step, shown as "Step 2" in Figure 3, in which the feature is fully formed. The plasma processing parameters used during the second plasma etch step are different to those used during the first plasma etch step. The second plasma etch step is an anisotropic plasma etch step. That is, the species forming the plasma are generally directed towards the substrate with a high degree of directionality. In this example, the species forming the plasma generally bombard the substrate substantially perpendicularly to the substrate surface. Consequently, the bottom surface 36b of high aspect ratio features can be etched without significant etching of the sidewalls.

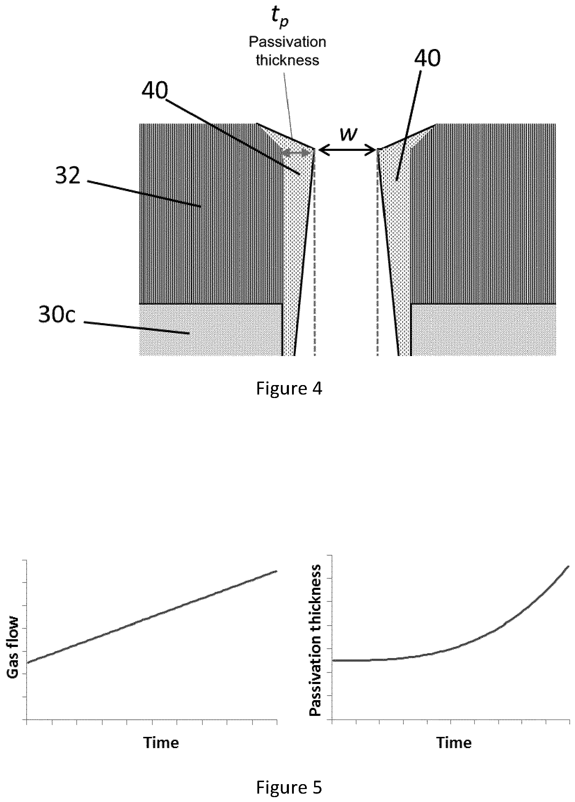

The second plasma etch step anisotropically etches the bottom surface 36b of the partially formed substrate. Simultaneously, a passivation material 40 is deposited onto a sidewall 42c of the mask 32 and also the sidewall 38 of the feature being etched (Figures 3 and 4). The passivation material 40 can be a silicon oxide, such as SiO₂. The passivation material and the mask can be made from the same material. Without wishing to be bound by any theory or conjecture, it is believed that the thickness (*tₚ*) of the passivation material 40 gradually increases during the second plasma etch step, which has the effect of gradually reducing a dimension in the opening of the mask or feature. The dimension can be a critical dimension, and can correspond to the minimum width (*w*) of the opening in the mask. This dimension can substantially correspond to the width on the bottom surface of the feature that is etched. As the dimension of the opening is reduced, the etching at the peripheral region 43 is attenuated. The change in the dimension *w* translates to a reduction in the etched width at the base of the feature. Without wishing to be bound by any theory or conjecture, it is believed that the passivation material 40 overhangs the corners of the base of the feature and consequently shields the corners of the base of the feature from the highly directional anisotropic plasma etch process. This has the effect of reducing the etch rate at the peripheral region 43 of the bottom surface (compared to a central region 39 of the bottom surface). As a result, a feature can be formed whereby the base of the feature has rounded corners, a tapered profile, or a rounded profile in an edge region 44 and a substantially flat central region 39. By controlling the rate of deposition of the passivation material (and hence by controlling the dimension of the opening in the mask) it is possible to control the profile at the base of the feature as desired.

Once the feature is fully formed, a further deposition-stripping step (shown as "Dep strip" on Figure 3) is performed to remove the passivation material from the side wall of the mask and feature. The removal of the passivation material can be performed using wet etching. For example, HF can be used as a wet etchant to remove the passivation material.

The resultant substrate 30d comprises a fully formed feature 34d which has a base having a substantially flat central region 39 and rounded or smoothed corners in an edge region 44 (or other shape as desired). A substrate which has a base or bottom surface with a smoothed profile (e.g. with rounded corners) can help to minimise field bunching. That is, the electric field is more uniformly dispersed about the feature. This can help to maximise breakdown voltages. Additionally, the present method helps to avoid the formation of micro-trenches at the corners of the feature being etched.

In order to control the profile of the base of the feature, it is necessary to control the rate of deposition of the passivation material 40. Typically, the second plasma etch step includes increasing the rate of deposition of the passivation material as the second plasma etch step proceeds. The rate of deposition of the passivation material can be controlled by varying one of the plasma process parameters. Any process parameter, including one or more of gas ratios, gas flow rates, etch time, plasma source power, platen power, and/or frequency of power applied, can be varied to control the deposition rate of the passivation material. For example, the deposition rate of the passivation material can be increased by gradually increasing (i.e. ramping) the rate of a gas that forms the passivation material (i.e. a passivation material precursor), such as an oxygen gas, introduced into the etch chamber during the second plasma etch step. In a further example, the rate of deposition of the passivation material can be increased by gradually reducing (i.e. ramping) the power applied to the platen during the second plasma etch step.

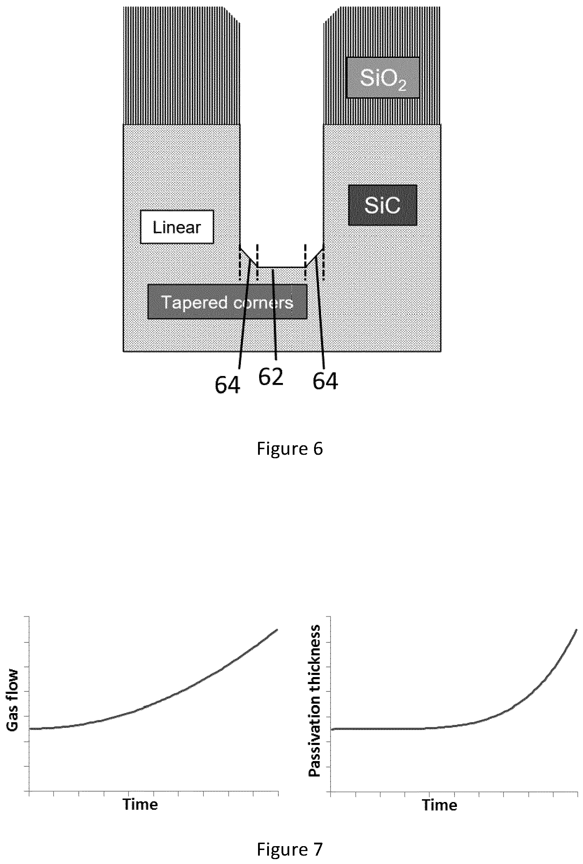

Figure 5 shows how a linear increase in passivation material precursor gas flow rate during the second plasma etch step corresponds to a change in passivation thickness. The linear increase in passivation material precursor flow rate results in a trench having a base with a tapered profile, as shown in Figure 6. That is, the slope at the corner of the feature (i.e. in the edge region 64) is substantially constant. The bottom surface of the feature comprises the tapered corners 64 and the substantially flat central region 62. Without wishing to be bound by any theory or conjecture, the parts of the feature that are covered by the passivation material (for example, where the passivation material overhangs the base of the feature) have a reduced etch rate. Consequently, as the passivation material thickness increases, this has the effect of reducing the dimension of the opening in the mask layer, and so the etchable width (w) at the base of the feature gradually decreases accordingly. This causes a tapered profile at the base of the feature.

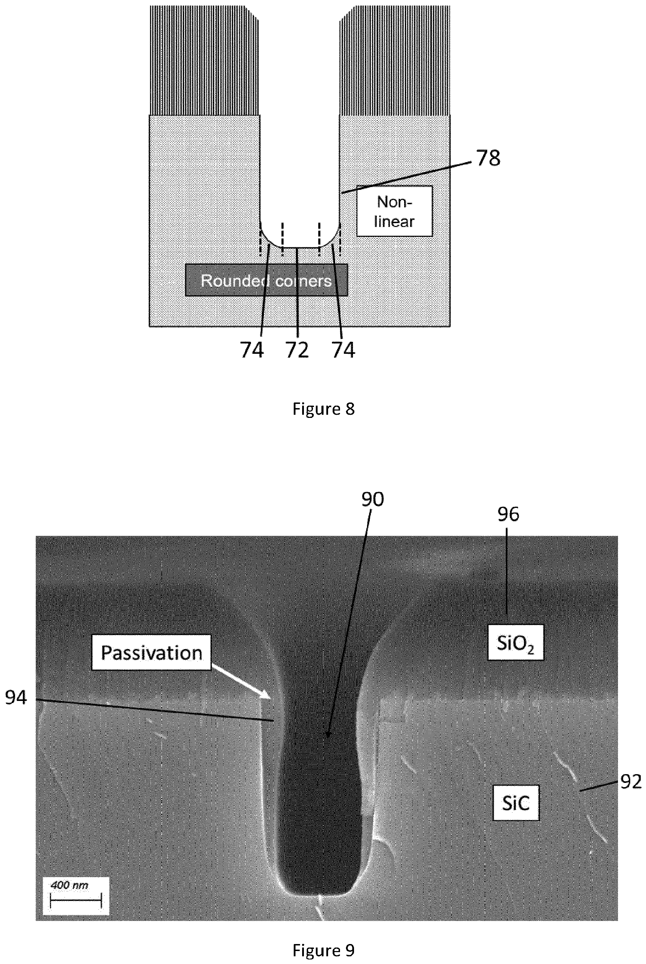

Figure 7 shows how a non-linear increase in passivation material precursor gas flow rate corresponds to a change in passivation thickness. More specifically, the gas flow of Figure 7 is increased (i.e. ramped) during the second plasma etch step at an increasing rate of change. The non-linear ramped increase in passivation material precursor gas flow rate results in a trench having a bottom surface having rounded corners. That is, the slope of the bottom surface in the edge region 74 gradually changes from horizontal (at the central region 72) to substantially vertical (at the sidewall 78), as shown in Figure 8.

Figure 9 shows an SEM image of a feature 90 that has been formed in a silicon carbide substrate 92 using the method describe above. Process parameters for the first and second steps are shown in Table 1:

**Table 1**

| | Step 1 | Step 2 |
|---|---|---|
| Time (s) | 90 | 115 |
| Pressure (mTorr) | 5 | 8 |
| Source coil power (W) | 950 | 1500 |
| Platen power (W) | 1400 | 250 →190 |
| Helium back-side pressure (Torr) | 10 | 10 |
| O₂ flow (seem) | 17 | 25 →98 |
| H₂ flow (seem) | 25 | 0 |
| Cl₂ flow (seem) | 130 | 0 |
| SiCl₄ flow (seem) | 19 | 160 |
| Platen temperature (°C) | 20 | 20 |

Figure 9 shows the passivation material 94 deposits on the sidewalls of the feature being formed, and also on the sidewall of the mask layer 96. The maximum thickness of the passivation material 94 was about 175 nm on each side of the feature 90. The etch rate during the first plasma etch step was about 400 nm/min.

By controlling the deposition rate of the passivation material, and hence by controlling the thickness of the passivation material, the dimension of the opening in the mask can be controlled. Control of this dimension allows the width of the etch at the base of the feature to be controlled, and can enable the shape of the bottom surface of the feature being etched to be controllably varied. The present method allows a feature, such as a trench, having a bottom surface with a controllable profile to be formed. Particular advantages are associated with a trench comprising a base with rounded corners. A rounded (or curved) corner can more uniformly distribute electric fields and therefore reduce field bunching. This can beneficially maximise breakdown voltages. Additionally, the present method can prevent the formation of micro-trenching at the corners of a feature because the etch rate is reduced in the corner of features during the second etch step.

## Claims

1. A method of plasma etching a compound semiconductor substrate to form a feature, the method comprising the steps of:
(a) providing a substrate with a mask formed thereon, the mask having an opening, wherein the substrate is formed from a compound semiconductor material;
(b) performing a first plasma etch step to anisotropically etch the substrate through the opening to produce a partially formed feature having a bottom surface comprising a peripheral region; and
(c) performing a second plasma etch step to anisotropically etch the bottom surface of the partially formed feature through the opening while depositing a passivation material onto the mask so as to reduce a dimension of the opening, wherein the reduction of the dimension of the opening causes an attenuation in etching of the peripheral region thereby producing a fully formed feature having a bottom surface comprising a central region and an edge region, wherein the central region is deeper than the edge region of the bottom surface of the fully formed feature.

2. A method according to claim 1, wherein the passivation material is deposited at a deposition rate that increases during the second plasma etch step.

3. A method according to claim 1 or 2, wherein the second etch step comprises varying a process parameter during the second plasma etch step.

4. A method according to claim 3, wherein the process parameter that is varied is ramped at an increasing rate of change.

5. A method according to claim 3 or 4, wherein varying the process parameter comprises varying a flow rate of a passivation material precursor during the second plasma etch step, optionally the flow rate of the passivation material precursor is increased during the second plasma etch step.

6. A method according to claim 5, wherein the passivation material precursor comprises an oxygen-containing gas, such as O₂.

7. A method according to any of claims 3 to 6, wherein varying the process parameter comprises varying a bias power applied to the substrate during the second plasma etch step, optionally the bias power applied to the substrate is decreased during the second plasma etch step.

8. A method according to any previous claim, wherein the passivation material comprises a silicon oxide, such as SiO₂.

9. A method according to any previous claim, wherein the passivation material and the mask are made of substantially the same material.

10. A method according to any previous claim, wherein the second plasma etch step includes using an etch recipe comprising a chlorine-based etchant, optionally the chlorine-based etchant comprises Cl₂ and/or SiCl₄.

11. A method according to claim 10, wherein the second plasma etch step includes using an etch recipe consisting essentially of: the chlorine-based etchant, an oxygen-containing gas, such as O₂ gas; optionally H₂ gas; and optionally Ar gas.

12. A method according to any previous claim, wherein the edge region of the bottom surface of the fully formed feature comprises a curved surface, optionally the edge region forms a rounded corner between the central region of the bottom surface and a sidewall of the fully formed feature.

13. A method according to any previous claim, wherein the compound semiconductor substrate is a silicon carbide (SiC) wafer.

14. A compound semiconductor substrate comprising a feature formed using the method according to claim 1, wherein the feature comprises a bottom surface, the bottom surface including a substantially flat central region and an edge region, wherein the central region is deeper than the edge region.

15. A plasma etch apparatus for plasma etching a substrate to form a feature using the method according to claim 1, the apparatus comprising:
a chamber;
a substrate support disposed within the chamber for supporting a substrate thereon;
at least one gas inlet for introducing a gas or gas mixture into the chamber at a flow rate;
a plasma generating means for sustaining a plasma in the chamber;
a power supply for supplying a bias power to the substrate support; and
a controller configured to switch from a first set of processing conditions to a second set of processing conditions, wherein the first set of processing conditions are configured to perform a first plasma etch step to anisotropically etch the substrate through an opening in a mask to produce a partially formed feature having a bottom surface comprising a peripheral region, and the second set of processing conditions are configured to perform a second plasma etch step to anisotropically etch the bottom surface of the partially formed feature through the opening whilst depositing a passivation material onto the mask so as to reduce a dimension of the opening, wherein the reduction of the dimension of the opening causes an attenuation in etching of the peripheral region thereby producing a fully formed feature having a bottom surface comprising a central region and an edge region, wherein the central region is deeper than the edge region of the bottom surface of the fully formed feature.
